# EUROPEAN PATENT APPLICATION

(11) **EP 2 908 244 A1**
(43) Date of publication of application: **19.08.2015**
(21) Application number: 15154805.4
(22) Date of filing: 12.02.2015
(51) Int. Cl.: G06F 9/44, G06F 11/36

(54) **Signal processing arrangement**

(30) Priority: 14.02.2014 FI 20145150
(71) Applicant: Streamr Oy, 00701 Helsinki (FI)
(72) Inventor: Pihkala, Henri, 00200 Helsinki (FI); Nylund, Nikke, 00120 Helsinki (FI)
(74) Representative: Berggren Oy Ab

(57) **Abstract**

A technique for defining and controlling a signal processing arrangement is provided. According to an example embodiment, the technique comprises an apparatus arranged to provide a graphical user interface (GUI) for controlling a signal processing arrangement for processing one or more input signals via one or more user-selectable and user-configurable signal processing modules. The GUI is configured to provide a user with selection means arranged to enable selecting one or more signal processing modules for inclusion in the signal processing arrangement, with definition means arranged to enable defining connections between the user-selected signal processing modules and between said one or more inputs of the signal processing arrangement and the user-selected signal processing modules and with configuration means arranged to enable configuring one or more dependency rules for the user-selected signal processing modules. The apparatus is further arranged to initiate carrying out the signal processing operations represented by one or more user-selected signal processing modules in accordance with a processing rule.

## Description

### TECHNICAL FIELD

The example and non-limiting embodiments of the present invention relate to a signal processing arrangement and, in particular, defining and operating a signal processing arrangement via a graphical user interface (GUI).

### BACKGROUND

Modern computer devices, even ones primarily intended for personal non- professional use, typically offer computing power that enables carrying out relatively complex data and/or signal processing operations, in many cases also in real time. Moreover, computer networks provide access to computer devices, e.g. server devices, which typically provide substantially higher computing power that may be useful or required in more complex data/signal processing operations. Since majority of the computer devices are connectable to a computer network, also personal computer can be arranged to have access to server devices and the computing resources available therein. On the other hand, computer networks, especially the Internet, provide a framework that enables access to a vast amount of information, processing of which by a personal computer or in control of a personal computer is likely to enable interesting applications for both personal and professional use.

While there are software applications and computing environments that may enable designing and testing processing arrangements for analyzing data or signals - either in real-time or offline, applications or environments that enable design of signal processing algorithms or arrangements are mainly targeted for professional use and usually fail to provide an intuitive and easy-to-use user interface that would make them applicable for wider audiences.

### SUMMARY

It is an object of the present invention to provide a graphical user interface (GUI) that enables a user to define a signal processing arrangement in a flexible and intuitive manner. It is another object of the present invention to provide a GUI that enables a user to configure and/or re-configure a signal processing arrangement in a flexible and intuitive manner. It is a further object of the present invention to provide a GUI that enables a user to operate and/or manage a signal processing arrangement in a flexible and computationally efficient manner.

According to a first example embodiment, an apparatus is provided, the apparatus comprising at least one processor and at least one memory including computer program code for one or more programs, the at least one memory and the computer program code configured to, with the at least one processor, cause the apparatus at least to provide a graphical user interface, GUI, for controlling a signal processing arrangement for processing one or more input signals via one or more user-selectable and user-configurable signal processing modules, wherein the GUI is configured to provide a user with selection means arranged to enable selecting one or more signal processing modules for inclusion in the signal processing arrangement, wherein each signal processing module represents one or more respective signal processing operations that involve computing one or more outputs of the signal processing module on basis of one or more inputs of the signal processing module, definition means arranged to enable defining connections between signal processing modules selected for inclusion in the signal processing arrangement and between one or more inputs of the signal processing arrangement and signal processing modules selected for inclusion in the signal processing arrangement to configure the signal processing arrangement, and initiate carrying out the signal processing operations represented by said signal processing modules selected for inclusion in the signal processing arrangement in accordance with a processing rule. Said processing rule is arranged to cause the apparatus to initiate, in response to detecting an event in one of the inputs of a signal processing module selected for inclusion in the signal processing arrangement, carrying out the signal processing operation represented by the respective signal processing module, wherein an event in an input of a signal processing module comprises a new value being pushed via the respective input of the respective signal processing module, and said GUI is configured to provide a user with configuration means comprising, for each input of each signal processing module selected for inclusion in the signal processing arrangement, a state control means arranged to enable enabling or disabling one or more predefined dependency rules for the respective input, wherein a predefined dependency rule, when enabled, is arranged to cause an exception to said processing rule for the respective signal processing module.

According to a second example embodiment, a method is provided, the method comprising providing a graphical user interface, GUI, for controlling a signal processing arrangement for processing one or more input signals via one or more user-selectable and user-configurable signal processing modules, receiving, via the GUI, selection of one or more signal processing modules for inclusion in the signal processing arrangement, wherein each signal processing module represents one or more respective signal processing operations that involve computing one or more outputs of the signal processing module on basis of one or more inputs of the signal processing module, receiving, via the GUI, definition of connections between signal processing modules selected for inclusion in the signal processing arrangement and between one or more inputs of the signal processing arrangement and signal processing modules selected for inclusion in the signal processing arrangement to configure the signal processing arrangement, and initiating carrying out the signal processing operations represented by said signal processing modules selected for inclusion in the signal processing arrangement in accordance with a processing rule. In the method, said processing rule causes initiating, in response to detecting an event in one of the inputs of a signal processing module selected for inclusion in the signal processing arrangement, carrying out the signal processing operation represented by the respective signal processing module, wherein an event in an input of a signal processing module comprises a new value being pushed via the respective input of the respective signal processing module, and the method further comprises receiving, via the GUI, for each input of each signal processing module selected for inclusion in the signal processing arrangement, configuration of a state control means arranged to enable enabling or disabling one or more predefined dependency rules for the respective input, wherein a predefined dependency rule, when enabled, is arranged to cause an exception to said processing rule for the respective signal processing module.

According to a third example embodiment, a computer program is provided, the computer program including one or more sequences of one or more instructions which, when executed by one or more processors, cause an apparatus at least to carry out the method according to the second example embodiment.

The computer program may be embodied on a volatile or a non-volatile computer-readable record medium, for example as a computer program product comprising at least one computer readable non-transitory medium having program code stored thereon, the program which when executed by an apparatus cause the apparatus at least to perform the operations described hereinbefore for the computer program according to the fifth aspect of the invention.

The exemplifying embodiments of the invention presented in this patent application are not to be interpreted to pose limitations to the applicability of the appended claims. The verb "to comprise" and its derivatives are used in this patent application as an open limitation that does not exclude the existence of also unrecited features. The features described hereinafter are mutually freely combinable unless explicitly stated otherwise.

The novel features which are considered as characteristic of the invention are set forth in particular in the appended claims. The invention itself, however, both as to its construction and its method of operation, together with additional objects and advantages thereof, will be best understood from the following detailed description of specific embodiments when read in connection with the accompanying drawings.

### BRIEF DESCRIPTION OF FIGURES

The embodiments of the invention are illustrated by way of example, and not by way of limitation, in the figures of the accompanying drawings.
Figure 1 schematically illustrates some components of an exemplifying computer apparatus in accordance with an example embodiment.
Figure 2 schematically illustrates an exemplifying GUI window in accordance with an example embodiment.
Figure 3 schematically illustrates an exemplifying GUI window in accordance with an example embodiment.
Figure 4 schematically illustrates an exemplifying GUI window in accordance with an example embodiment.
Figure 5 schematically illustrates an exemplifying signal processing module according to an example embodiment.
Figure 6 illustrates a method according an embodiment.

### DESCRIPTION OF SOME EMBODIMENTS

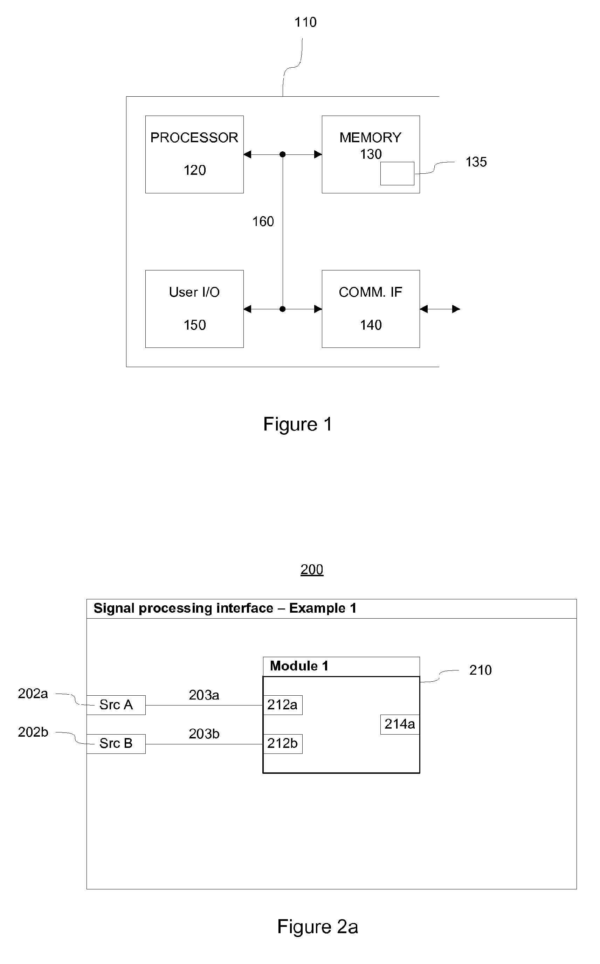

Figure 1 schematically illustrates some components of an exemplifying computer apparatus 110. The computer apparatus 110 comprises a processor 120, which may serve as a central processing unit (CPU) of the computer apparatus 110. The computer apparatus further comprises a memory 130 for storing data and/or program code for one or more computer programs. The computer apparatus 100 further comprises a communication interface 140, e.g. a network adapter, which enables wireless and/or wired communication with other computer apparatuses. The computer apparatus further comprises one or more input/output (I/O) components 150 to enable the computer apparatus 110 to receive input from a user and/or to provide output to the user. The I/O components 150 may include, for example, one or more of the following: a display, a touchscreen, a touchpad, a keyboard or a keypad, a mouse or a pointing device of other type, etc. The computer apparatus 110 may be, for example, a personal computer such as a laptop computer or a desktop computer, a tablet computer, a personal digital assistant (PDA), a mobile phone or a smartphone, etc.

Although in Figure 1 the processor 120 is depicted as a single component, the processor 120 may be implemented as one or more separate components. Similarly, although the memory 130 is illustrated as a single component, the memory 130 may be implemented as one or more separate components. Some or all of such memory components may be integrated/removable and/or may provide permanent / semi-permanent / dynamic / cached storage.

A portion of the program code stored in the memory 130, when executed by the processor 120, may be arranged to provide an operating system arranged to control operation of the computer apparatus 110. Another portion of the program code stored in the memory 130 may be arranged, when executed by the processor 120, together with the operating system to provide a user interface that allows the user to operate the computer apparatus 110 with the aid of the I/O components 150. Hence, the processor 120 may be arranged to control operation of the computer apparatus 110 in accordance with program code stored in the memory 130 and/or in accordance with user input received via the user interface.

The memory 130 may be further arranged to store a computer program code 135 comprising one or more sequences of one or more instructions that, when executed by the processor 120, causes the computer apparatus 110 to operate a signal processing application. The computer program code 135 may constitute that a stand-alone computer program that is executable by the computer apparatus 110 independently of further applications in the framework provided by the operating system. As another example, the computer program code 135 may comprise instructions that are executable in context of another application provided in framework provided by the operating system. An example of such another application is a browser application that enables the user to access resources that are available in the computer apparatus 110 or, via the communication interface 140, resources that are available in the other apparatuses.

The components of the computer apparatus 110, e.g. the processor 120, the memory 130, the communication interface 140 and said I/O components, are typically interconnected by a bus 160. The bus 160 is arranged to provide electrical connection(s) between components of the computer apparatus 110 for transfer of control information, address information and/or data. The computer apparatus 110 serves as an illustrative and non-limiting example of an apparatus that is suitable for executing the program code 135 arranged to provide the signal processing application. Hence, an apparatus comprising additional components and/or an apparatus not comprising all components described in context of the computer apparatus 110 may be employed instead.

The signal processing application is arranged to cause providing, via the display of the computer apparatus 110, a GUI to enable a user to control and configure the operation of the signal processing application. In particular, the GUI is configured to provide the user with means for defining, configuring and/or controlling a signal processing algorithm to be carried out in control of the signal processing application. The signal processing application is further arranged to initiate carrying out signal processing operations represented by the signal processing modules of the user-defined the signal processing algorithm in accordance with a processing rule. Herein, the signal processing algorithm is also referred to as a signal processing arrangement.

The term signal processing as used herein should be construed broadly. This term is used to refer to processing of any data. As an example, the term signal processing may refer to processing of any data presented in a numerical format and for which signal processing operations that rely on computation of mathematical operations. As an example, such data may represent a real world signal, such as an audio signal, a video signal, an image, etc. As another example, such data may represent measurement data from a sensor arranged to measure an environmental parameter such as temperature, air pressure, CO₂ level, etc. As a further example, the data may be other numerical data, e.g. stock market data, pricing data, etc. As another example, additionally or alternatively, the term signal processing may refer to processing of data presented as text. As an example in this regard, the processing of text may involve e.g. processing in order to detect absence or presence of one or more predefined individual characters or one or more predefined sequences of characters in input data provided as text. As another example, the processing of data provided as text may involve e.g. arranging data items received as text into a desired (ranking) order in accordance with a predefined rule. However, the details of the applied signal processing operations as well as the format of the processed data are outside the scope of the present invention. Therefore, for clarity and brevity of description, the operation of the signal processing application is described in the following with references to processing of numerical data (to extent such references are considered useful in illustrating the operation of the signal processing application in accordance with an embodiment of the present invention),

The GUI is arranged to provide the user with means to control a signal processing arrangement, e.g. to define, to configure, to re-configure and/or to operate the signal processing arrangement. The control may be provided by the user making use of one or more of the I/O components 150, e.g. a keyboard, a mouse, a touchpad, a touchscreen or a pointing device of another type to operate the control means provided by the GUI. The GUI is further arranged to display via one or more of the I/O components 150, e.g. via a display or a touchscreen of the computer apparatus 110, a visualization of the user-defined or user-configured signal processing arrangement.

In the GUI, the signal processing arrangement is defined by one or more user-selected signal processing modules, each signal processing module representing respective one or more signal processing operations. Each signal processing module comprises one or more inputs and one or more outputs, and the signal processing operation(s) represented by a signal processing module are arranged to compute one or more output values of the signal processing module at least on basis of the input value(s) of the signal processing module. The user-definable connections from input(s) of the signal processing arrangement to one or more user-selected signal processing module(s) and/or from output(s) of user-selected signal processing module(s) to input(s) of user-selected signal processing module(s) define the signal processing arrangement (i.e. the signal processing algorithm) to be carried out by the signal processing application. Hence, the signal processing arrangement defines the signal processing operation(s) for deriving one or more outputs of the signal processing arrangement on basis of one or more input signals of the signal processing arrangement. An input of the signal processing arrangement may also be referred to as a (respective) input signal (of the signal processing arrangement) whereas an output of the signal processing arrangement may also be referred to as a (respective) output signal (of the signal processing arrangement).

The GUI provides the user with module selection means arranged to enable selecting the signal processing modules and with connection definition means arranged to enable defining the connections between the user-selected signal processing modules to define the signal processing arrangement (i.e. the signal processing algorithm). Exemplifying details regarding the operation of the signal processing application and the GUI are provided in the following.

The content and format of the GUI as displayed to the user depends on the currently defined signal processing arrangement or the signal processing arrangement currently under construction by the user. The GUI may cover the display of the computer apparatus 110 in its entirety, or the GUI may cover only a portion of the display. The GUI may be provided as a window or as a corresponding visual element of the user interface that allows the user to operate the computer apparatus 110. In the following, the GUI is described with a reference to a GUI window. Moreover, in order to illustrate various aspects of the GUI, a number of exemplifying signal processing arrangements are described in the following in context of a number of exemplifying GUI windows.

Figure 2a schematically illustrates an exemplifying GUI window 200 displaying a first exemplifying signal processing arrangement. The GUI window 200 includes a signal processing module 210. The signal processing module 210 has a first input 212a, a second input 212b and a single output 214a. A first input 202a of the signal processing arrangement is connected to the first input 212a of the signal processing module 210 via a first connection 203a. A second input 202b of the signal processing arrangement is connected to the second input 212b of the signal processing module 210 via a second connection 203b. The output 214a of the signal processing module 210 constitutes the output of the exemplifying signal processing arrangement depicted in Figure 2a.

The signal processing module 210 represents a predefined signal processing operation. The signal processing module 210 is selected by the user from a plurality of available predefined signal processing modules, each representing a respective predetermined signal processing operation. In this regard, the GUI is arranged to provide the user with module selection means that are arranged to enable selecting a signal processing module from a set of available signal processing modules. The selection means may be provided e.g. by displaying a list of available signal processing modules (e.g. as a menu or a submenu) for the user to choose from. Displaying the list may be invoked for example
- by the user selecting from a menu bar (that may be provided as part of the GUI) a menu bar item that is arranged to cause displaying the list of predefined signal processing modules,
- by the user selecting from a drop-down menu displayed in response to the user selecting via a menu bar (that may be provided as part of the GUI) a menu item that is arranged to cause displaying the list of predefined signal processing modules, or
- by the user selecting from a pop-up menu displayed in response to the user selecting an option to display the pop-up menu (e.g. right-click mouse operation) a menu item that is arranged to cause displaying the list of predefined signal processing modules.

As a further example, the GUI may be arranged to provide a selection button (a command button, a push button, etc.) arranged to cause displaying the list of predefined signal processing modules. As a yet further example, the GUI may be arranged to provide a plurality of selection buttons, each selection button arranged to cause selection of a respective signal processing module. Such selection buttons may be provided for each of the available signal processing module or to a limited subset of the available signal processing modules.

In general, several (further) techniques for selecting an item from a plurality of predetermined items in context of graphical user interfaces are known in the art, and the list of available signal processing modules may be provided using any such technique without departing from embodiments of the present invention.

When the user has selected a signal processing module, the signal processing application is configured to cause displaying the selected signal processing module in the GUI window. The signal processing module may be initially displayed e.g. in an arbitrary position or in a predefined position of the GUI window. The signal processing application and/or the GUI is arranged to provide the user with positioning means that are arranged to enable moving the displayed signal processing module within the GUI window and deletion means that are arranged to enable removing a displayed signal processing module from the GUI window (and hence from the user-defined signal processing arrangement).

The signal processing operation represented by the signal processing module 210 involves computing the value for the output 214 at least on basis of the value(s) received inputs 212a, 212b. This may be considered as computing the output value as a function of the input values. Such function may be e.g. a linear or a non-linear function of the current (or most recent) input values the input values. Non-limiting examples of such function include
- a sum of the input values,
- a difference between the input values,
- a product of the input values,
- a weighted sum (e.g. an average or another linear combination) of the input values,
- a minimum of the input values,
- a maximum of the input values.

Instead of considering only the current values of the inputs 212a, 212b, the signal processing operation may further consider the current internal state of the signal processing module 210 in computation of the output value. The current internal state may depend on and/or may be defined by one or more preceding values of the inputs 212a, 212b and/or the output 214. Additionally or alternatively, the current internal state may depend on and/or may be defined by one or more internal state variables determined on basis of the one or more preceding values of the inputs 212a, 212b and/or the output 214. As an example in this regard, assuming that the internal state is defined by the one or more predefined values of the inputs 212a, 212b, a first intermediate value may be derived as a linear or non-linear function of the current value and one or more preceding values of the first input 212a, while a second intermediate value may be derived as a linear or non-linear function of the current value and one or more preceding values of the second input 212b. The first and/or the second intermediate values may be derived e.g. as a linear combination (e.g. as an average) of the current value and one or more preceding values of the respective input 212a, 212b, as a median of the current value and one or more preceding values of the respective input 212a, 212b, etc. Consequently, the output value may be derived as a (linear or non-linear) function of the first and second intermediate values, e.g. along the lines described above for the current input values.

The number of preceding values considered in derivation of the first and/or the second intermediate value may be defined as a predetermined number of most recent values in the respective input 212a, 212b. As another example, values considered in derivation of the first and/or second intermediate value may comprise the preceding values of the respective input 212a, 212b received within a time window of predefined (temporal) duration.

The signal processing module 210 is illustrated in the GUI window 200 with two inputs 212a and 212b and with a single output 214a. However, in general, a signal processing module may be provided with one or more inputs and/or with one or more outputs, depending on the characteristics of the signal processing operation(s) represented by the signal processing module. Moreover, although the GUI window 200 depicts two inputs 202a, 202b of the signal processing arrangement, in general one or more inputs may be employed and the number of the inputs may be user-selectable (as will be described later in this text).

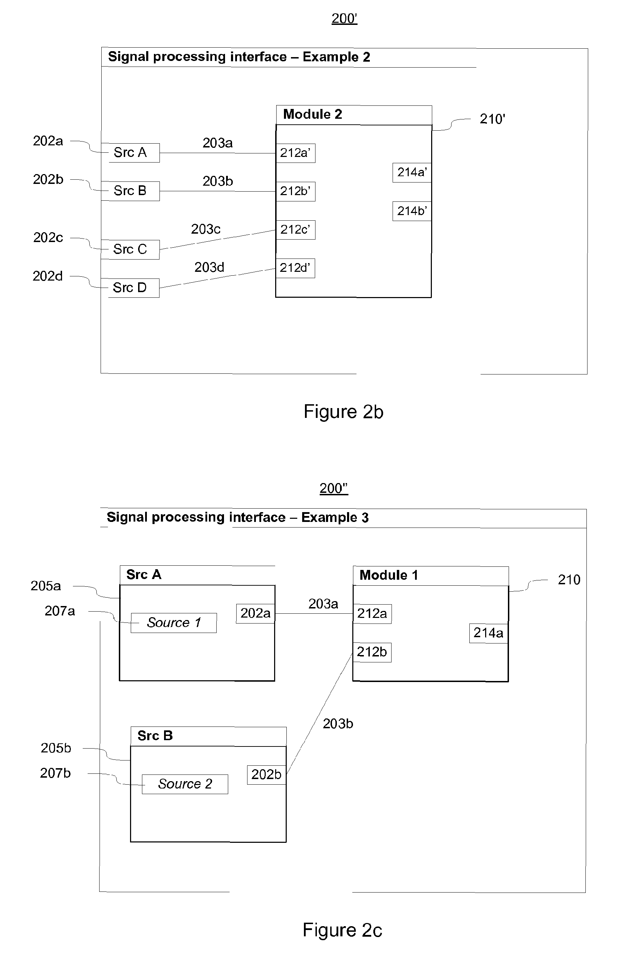

As an example in this regard, Figure 2b schematically illustrates an exemplifying GUI window 200', which is a variation of the GUI window 200. The GUI window 200' includes a signal processing module 210' that has four inputs 212a', 212b', 212c' and 212d' and two outputs 214a', 214b' and 214c'. In the signal processing arrangement of the GUI window 200', the first input 202a is connected to the input 212a' of the signal processing module 210' via the connection 203a. Along similar lines, the second input 202b is connected to the input 212b' of the signal processing module 210' via connection 203b, a third input 202c is connected to the input 212c' of the signal processing module 210' via connection 203c and a fourth input 202d is connected to the input 202d' of the signal processing module 210' via connection 203d.

Multiple outputs of a signal processing module provide more versatile possibilities to provide (or design) signal processing modules that compute e.g. predetermined statistical parameters on basis of the current (or most recent) values of the input(s) together with zero or more preceding values of the input(s). As a non-limiting example in this regard, the signal processing module 210' may represent signal processing operations that define the value for the output 214a' as the average of the current values of the inputs 212a', 212b', 212c' and 212d' and the value for the output 214b' as the maximum (or minimum) of the current values of the inputs 212a', 212b', 212c' and 212d.

In the foregoing, the exemplifying GUI windows 200 and 200' the inputs 202a, 202b, 202c and 202d of the signal processing arrangement are depicted as simple 'blocks' in the GUI. In this regard, the GUI element arranged to represent an input 202x of the signal processing arrangement may be provided, for example, as a text box or a corresponding GUI element that allows the user to define (e.g. to type) the resource serving as the respective input for the signal processing arrangement. Moreover, the GUI may be configured to provide the user with means that enable adding or removing a text box (or a corresponding GUI element) representing an input of the signal processing arrangement to/from the GUI window.

As another example, an input 202x of the signal processing arrangement may be provided by a respective source module that represents the resource selected to provide the respective input 202x such that the input 202x is provided as an output of the respective source module. Figure 2c schematically illustrates an exemplifying GUI window 200", which is a variation of the GUI window 200. The GUI window 200" includes the signal processing module 210 depicted in the GUI window 200. On the other hand, the input 202a is provided as an output of a source module 205a and the input 202b is provided as an output of a source module 205b. Like in the GUI window 200, the input 202a is connected to the input 212a of the signal processing module 210 via the connection 203a, and the input 202b is connected to the input 212b of the signal processing module 210 via the connection 203b.

The source modules 205a, 205b include a respective text box 207a, 207b that enables the user to define (e.g. to type) the resource serving as the input of the signal processing arrangement represented by the respective source module 205a, 205b. Instead of or in addition to the text box 207a, 207b, a GUI element of other type that enables the user to define or select the resource serving as the input for the signal processing arrangement represented by the respective source module 205a, 205b.

Hence, the module selection means may be further arranged to enable selecting a source module from a set of available source module types (e.g. by including the source module types as additional items in the list of available signal processing modules). Moreover, the signal processing application is configured to cause displaying selected source module in the GUI window in response to the user employing the module selection means to select a source module. Furthermore, the positioning means may be further arranged to enable moving the displayed source module within the GUI window and the deletion means may be further arranged to enable removing a displayed source module from the GUI window (and hence from the user-defined signal processing arrangement).

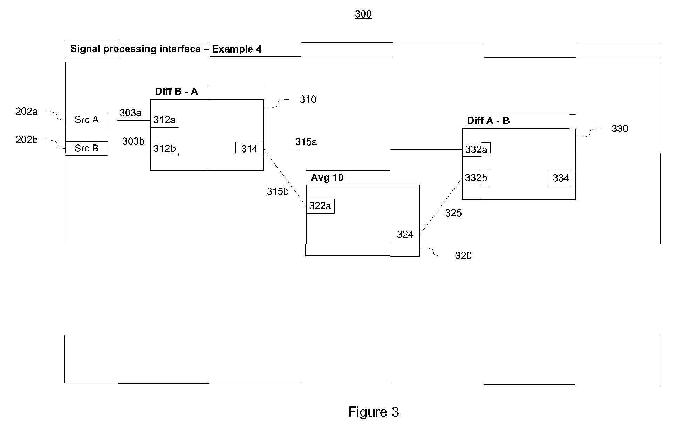

For clarity and brevity of description and illustration, in the following GUI window examples the inputs of the signal processing arrangements are described and depicted as simple 'blocks' in the GUI, along the lines done in Figures 2a and 2b. However, this is a non-limiting choice made in the interest of clarity of illustration and such 'blocks' in the GUI windows depicted in Figures 3 to 5 may be replaced by the text box(es) (along the lines described in context of the example GUI windows 200 and 200'), by the source module(s) (along the lines described in context of the example GUI window 200") or by a corresponding GUI element or GUI mechanism.

The GUI may be configured to provide the user with resetting means arranged to enable resetting the internal state of the signal processing module 210 to a default state. Resetting may involve setting any state variables associated with the signal processing module 210, 210', 210" to predefined default values, e.g. to zeros. As an example, the default state may involve setting the state variables indicating the preceding values of the inputs of the signal processing module 210, 210', 210" (and possibly the preceding values of the outputs of the signal processing module 210, 210', 210") to the predefined default values. The resetting means may comprise e.g. selection button provided in the signal processing module 210, 210', 210", activation of which causes the signal processing application to reset the internal state. Additionally or alternatively, the resetting means may comprise a selection button, activation of which is arranged to cause providing the user with a text box or a corresponding GUI element that allows the user to define (e.g. to type) a resetting rule for restoring the default state of the signal processing module 210, 210', 210" at desired intervals (defined e.g. as hours, minutes and/or seconds) or for restoring the default state at a specified time of day.

The connections 203a, 203b link the respective inputs 202a, 203b of the signal processing arrangement to the corresponding inputs 212a, 212b of the signal processing module 210. In other words, the connections 203a, 203 and characteristics of the signal processing module 210 define the signal processing operations to be applied to the values received via the inputs 202a, 203b in order to derive the value at the output 214 of the signal processing module 210 in context of the GUI window 200. Along similar lines, the connections 203a, 203b, 203c, 203d link the respective inputs 202a, 202b, 202c, 202d of the signal processing arrangements to corresponding inputs 212a', 212b', 212c', 212d' of the signal processing module 210', thereby defining the signal processing arrangement depicted in the GUI window 200'. Furthermore, the connections 203a, 203b link the respective source modules 205a, 205b to corresponding inputs 212a, 212b of the signal processing module 210, thereby defining the signal processing arrangement depicted in the GUI window 200".

To further illustrate the selection of the signal processing modules and definition of the connections between the inputs 202a, 202b, 202c, 202d of the signal processing arrangement and one or more user-selected signal processing modules as well as definition of the connections between the user-selected signal processing modules, Figure 3 schematically illustrates an exemplifying GUI window 300 displaying a further example of the signal processing arrangement. The GUI window 300 includes the inputs 202a, 202b described in context of the GUI windows 200, 200' and 200". The GUI window 300 further includes a first signal processing module 310, a second signal processing module 320 and a third signal processing module 330.

The first signal processing module 310 is arranged to compute the difference between current (or most recent) value received in a second input 312b thereof and the current (or most recent) value received in a first input 312a thereof and to provide the computed difference via an output 315 of the first signal processing module 310. Connection 303a connects the input 202a to the input 312a and connection 303b connects the input 202b to the input 312b. Connection 315a connects the output 314 to an input 322a of the second signal processing module 320, whereas connection 315b connects the output 314 to a first input 332a of the third signal processing module 330. The second signal processing module 320 is configured to compute an average of 10 most recently received values of the input 322a and to provide the computed average via an output 324 of the second signal processing module 320. The connection 325 connects the output 324 to a second input 332b of the third signal processing module 330. The third signal processing module 330 is arranged to compute the difference between current (or most recent) value received in the first input 332a and the current (or most recent) value received in the second input 332b and to provide the computed difference for an output 334 of the third signal processing module 330. Hence, the signal processing arrangement depicted in the GUI window 300 is arranged to compute the difference between instantaneous difference between the inputs 202b and 202a and the average of the differences between the inputs 202b and 202a, wherein the average is computed over a time window of 10 most recent values). While, typically, the output 334 of the third signal processing module constitutes an output of the signal processing arrangement depicted in Figure 3, the output of first signal processing module 310 and/or the output of the second signal processing module 320 may constitute further output(s) of the signal processing arrangement. This aspect of the signal processing application will be described in more detail later in this text.

In order to enable defining a signal processing arrangement of interest, the GUI is configured to provide the user with connection definition means arranged to enable defining connections from the inputs of the signal processing arrangement (e.g. from respective source modules) to one or more user-selected signal processing modules 210, 310 as well as connections from one signal processing module 310, 320 to another user-selected signal processing module 320, 330. The connection definition means may be arranged to enable the user to select end points for a connection e.g. as a 'drag and drop' operation that may involve the user moving a pointer object in the location of the desired end-point in the GUI and pressing a selection button (e.g. the left mouse button), moving the pointer object to the location of the desired other end point of the connection while holding the selection button, and releasing the selection button while the pointer object is kept in the location of the desired other end-point.

The user-defined connection may define a connection that is one of the following types
- a connection from the input of the signal processing arrangement (e.g. from an output of a source module) to an input of a signal processing module,
- a connection from the output of a signal processing module to an input of another signal processing module,
- a connection from the output of a signal processing module to an input of the same signal processing module,

When the user has defined a connection, the signal processing application is configured to cause displaying the defined connection (e.g. between an input of the signal processing arrangement and a signal processing module or between two signal processing modules) in the GUI window. If the user applies the positioning means to move a displayed signal processing module (or a source module) that is connected to another user-selected entity displayed in the GUI window, the signal processing application and/or the GUI is arranged to update the GUI window accordingly. The GUI is further configured to provide the user with connection deletion means that are arranged to enable deleting a connection between entities displayed in the GUI and the signal processing application and/or the GUI is configured to update the GUI window accordingly in response to the user employing the connection deletion means to delete a connection.

While the example GUI windows 200, 200' and 200" illustrate signal processing arrangements of a single signal processing module and the example GUI window 300 illustrates a signal processing arrangement of three signal processing modules, the signal processing application and/or the GUI enable inclusion of any number of signal processing modules and definition of any connections therebetween along the lines described in the foregoing. Consequently, the signal processing application and/or the GUI provide a flexible and intuitive technique for defining a signal processing arrangement of interest.

The inputs 202a, 202b, 202c, 202d of the signal processing arrangement are user-definable. In this regard, as described in the foregoing, the GUI may be arranged to provide the user with input definition means arranged to enable defining one or more inputs 202a, 202b e.g. as text boxes (or corresponding GUI elements/mechanism).

An input of the signal processing arrangement may be defined, for example, as a resource accessible via a computer network. Such resource may comprise e.g. a script or a computer program executed in a remote server apparatus, the script or the computer program arranged to push input values to the respective input 202a, 202b of the signal processing arrangement. In such a scenario the user may be able to define a Uniform Resource Identifier (URI) that identifies the resource of interest. As another example, such resource accessible via a computer network may comprise a webpage or a file provided at a remote server apparatus, the webpage or file providing (and typically regularly updated with) information in a predefined format to be used as input to the signal processing arrangement. Data from such type of a resource may be obtained by polling the content of the webpage/file according to predefined (or user-defined) schedule, e.g. at regular intervals. Hence, the input definition means may be provided e.g. as a text box or as a corresponding GUI element into which the user is able to type the URI defining the resource to be used as the respective input of the signal processing arrangement or as a selection tool (e.g. a selection window) that enables the user to select or identify the resource to be applied as the respective input of the signal processing arrangement.

As a further example, the input 202a, 202b, 202c, 202d of the signal processing arrangement may be obtained (e.g. read) from a file (or from another data structure) stored locally in the computer apparatus 110, e.g. in the memory 130 or in a mass storage device included in or connected to the computer apparatus 110. In such a scenario the user may be able to define the name of the file that is employed as the respective input, and the means for defining the inputs 202a, 202b (or sources) may be provided as a text box or as a corresponding GUI element into which the user is able to type the file name or as a selection tool (or selection window) that enables the user to select or identify a file of interest from a file system accessible by the computer apparatus 110.

As referred to in the foregoing, e.g. in the exemplifying GUI window 200 the output 214 of the (sole) signal processing module 210 constitutes the (sole) output of the signal processing arrangement, whereas in the exemplifying GUI window 300 the output 334 of the first signal processing module 330 constitutes one output of the signal processing arrangement with the outputs 314 and 324 of the first signal processing module 310 and the second signal processing modules 320, respectively, possibly constituting further output(s) of the signal processing arrangement. A predefined signal processing module may be explicitly defined as a signal processing module further serving as an output of the signal processing arrangement of a predetermined type. As another example, the GUI may be configured to provide the user with output setting means arranged to enable setting or selecting the output of one or more of the user-selected signal processing modules 210, 210', 310, 320, 330 to further represent an output of the signal processing arrangement. The output setting means may comprise e.g. a checkbox, a radio button or a corresponding selection mechanism provided in the respective signal processing module.

Further in this regard, the GUI may be arranged to provide the user with output type definition means arranged to enable defining the type of the output for those signal processing modules that represent an output of the signal processing arrangement. These output type definition means may comprise a GUI element or a GUI mechanism for selecting the type of the target from a list of predefined options. The predefined options may include e.g. one or more of the following: storing the output value in a file in the file system of the computer apparatus 110 or in a file system of another apparatus, displaying the output value in a graphical representation of the (respective) output values displayed via the GUI, providing the output value for transmission to a remote apparatus and/or a remote user (e.g. over a telecommunication network). Moreover, the output type definition means may further comprise output target definition means arranged to enable specifying the target. The output target definition means may be provided e.g. as a text box or as a corresponding GUI element or GUI mechanism (e.g. as a selection window or as a selection tool of other type) that enables the user inserting or selecting a file name or a URI, identifying or selecting the graphical representation, identifying or selecting the remote apparatus and/or the remote user.

As briefly referred to in the foregoing, the signal processing application is arranged to initiate the signal processing operation(s) represented by one or more of the user-selected signal processing modules in accordance with the predetermined processing rule.

The processing rule may be arranged to cause the apparatus to initiate carrying out the signal processing operation(s) represented by a user-selected signal processing module included in the user-defined signal processing arrangement in response to a new value being made available in at least one of the inputs of the respective signal processing module. Hence, a signal processing operation(s) are initiated in response to detecting an event in one of the inputs of the signal processing module representing the signal processing operation(s). The event may comprise a new value being pushed via one of the inputs 202a, 202b, 202c, 202d of the signal processing arrangement or a new value being made available in an output of one of the user-selected signal processing modules and pushed to another signal processing module via an input thereof that is connected to said output. As another example, the event may comprise detecting a new value (or a change of value) in one of the inputs 202a, 202b, 202c, 202d of the signal processing arrangement or in an input of one of the user-selected signal processing modules, where the new value (or the change of value) may be detected when polling the respective input.

Consequently, an event in one of the inputs 202a, 202b, 202c, 202d of the signal processing arrangement may result in a chain of events: first, the signal processing operation(s) represented by the signal processing module(s) connected to the input 202a, 202b, 202c, 202d in which the event is detected are initiated (and carried out). This results in an event in input(s) of the signal processing modules connected to the output(s) of the signal processing module(s) invoked by the event in one of the inputs 202a, 202b, 202c, 202d, causing the signal processing operation(s) represented by the affected signal processing modules to be initiated (and carried out) and so on. Consequently, as a general rule, when applying such an event-based processing rule an event in one of the inputs 202a, 202b, 202c, 204d causes carrying out the signal processing operation(s) represented by the user-selected signal processing modules, which in turn results in updating the output(s) of the signal processing arrangement. Such an event-based processing rule enables continuous on-line (or real-time) processing of data that is updated over time.

Alternatively or additionally, the processing rule may be arranged to cause the apparatus to initiate carrying out the signal processing operations represented by all user-selected signal processing modules of the signal processing arrangement in response to a user-initiated request. In this regard, the GUI may be configured to provide the user with initiation means arranged to enable requesting the signal processing operations represented by the user-defined signal processing arrangement to be carried out. The initiation means may comprise e.g. a selection button or a corresponding GUI element that is arranged to invoke the request to initiate carrying out the signal processing operations.

Alternatively or additionally, the processing rule may be arranged to cause the apparatus to initiate carrying out the signal processing operations represented by all user-selected signal processing modules of the signal processing arrangement in accordance with a user-defined schedule. In this regard, the GUI may be configured to provide the user with definition means arranged to enable defining the schedule for initiating the signal processing operations. These definition means may comprise e.g. a text box or a corresponding GUI element that allows the user to type the interval (e.g. as hours, minutes and/or seconds) of invocation of the signal processing operations.

While the user-initiated request or the user-defined schedule to initiate the processing involved in the signal processing arrangement is applicable also to online (or real-time) processing of data, they may be particularly suitable for offline processing of data, e.g. for testing or verification of the signal processing arrangement under development.

The signal processing operation represented by a user-selected signal processing module may be carried (locally) by the computer apparatus 110 running the signal processing application. Alternatively, the signal processing operation represented by the user-selected signal processing module may be carried out by a remote computer apparatus. In the latter approach, the signal processing application causes the computer apparatus 110 to provide the inputs for the remote apparatus, which carries out the respective signal processing operation and returns the output to the computer apparatus 110. A signal processing arrangement may comprise a mixture of signal processing modules representing signal processing operations to be carried out locally by the computer apparatus 110 and signal processing modules representing signal processing operations to be carried out remotely by a remote computer apparatus.

In case all signal processing operations included in a signal processing arrangement are carried out by a remote computer apparatus, the remote computer apparatus is preferably configured to provide outputs of all signal processing modules to the computer apparatus 110 for use as an output of the signal processing arrangement from those signal processing modules that are defined (e.g. predefined or defined by the user) to represent an output of the signal processing arrangement. Alternatively, indication(s) of the signal processing modules defined to represent an output of the signal processing arrangement are provided to the remote computer apparatus together with the respective inputs, and the remote computer apparatus is configure to provide the computer apparatus 110 only with those outputs that are indicated to represent an output of the signal processing arrangement.

Although referred to herein as a remote computer apparatus in singular, the remote processing of one or more signal processing operations may be carried out by a plurality of remote computer apparatuses. In other words, the respective signal processing operation(s) may be carried out as distributed computing (e.g. cloud computing) carried out by the plurality of (remote) computer apparatuses.

Instead of or in addition to defining one or more of the user-selected signal processing modules to (also) represent an output of the signal processing arrangement, a dedicated reporting module representing an output of the signal processing arrangement may be applied. In this regard, the selection means may be further arranged to enable selecting a reporting module from a set of available predefined reporting module types and the connection definition means may be further arranged to enable connecting an output of a user-selected signal processing module to an input of a reporting module. The reporting module, in turn, represents provision of the value provided in its input as an output of the signal processing arrangement. The type of a reporting module may define the type of the target for the respective output of the signal processing arrangement. Examples of target types are described in the foregoing in context of the output of a signal processing module also representing an output of the signal processing arrangement. In this regard, the GUI may be configured to provide the user with target definition means arranged to enable specifying the target for the output, e.g. to insert a file name or a URI, to identify the graphical representation, to identify the remote apparatus and/or the remote user by typing the respective information to a text box or to a corresponding GUI element.

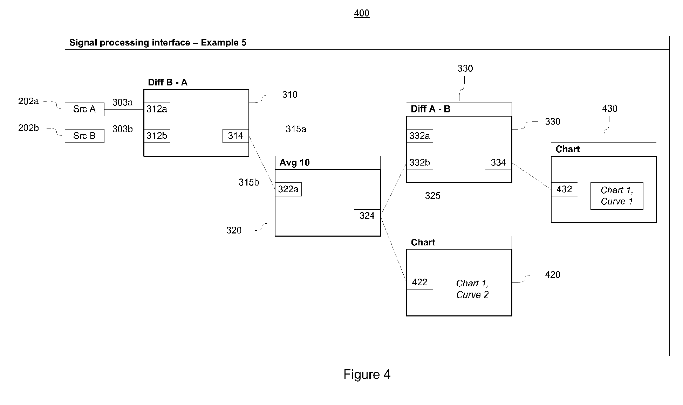

To illustrate the usage of a reporting module, Figure 4 depicts an exemplifying GUI window 400, which is a variation of the GUI window 300. The GUI window 400 depicts the elements illustrated in Figure 3 together with a first reporting module 420 and a second reporting module 430. The output 324 of the second signal processing module 320 is connected to an input 422 of the first reporting module 420 and the output 334 of the third signal processing module 330 is connected to an input 432 of the second reporting module 430. The reporting modules 420, 430 may be arranged to provide the respective outputs for illustration as part of respective curves in a graphical representation provided in the GUI (not shown). Hence, the difference to the GUI window 300 is that while in the GUI window 300 the outputs of the signal processing modules 320 and 330 may be defined or selected to also serve as respective outputs of the signal processing arrangement, in the GUI window 400 the reporting modules 420 and 430 explicitly indicate the outputs of the signal processing arrangement.

In the foregoing, a reference is made to available predefined signal processing modules, each of which represents a respective predefined signal processing operation. Additionally, the available signal processing modules may include a user-definable signal processing module. In this regard, the GUI may be configured to provide the user with definition means arranged to enable defining the signal processing operation represented by a user-selected user-definable signal processing module. The definition means may be provided e.g. as a selection button or as a corresponding GUI element (provided/displayed e.g. as part of the respective signal processing module) activation of which is arranged to cause displaying a dialog box or a corresponding GUI element that enables the user at least to define the number of inputs for the respective user-definable signal processing module and to define (e.g. to type) the desired signal processing operation using a suitable script language.

The GUI may be further configured to provide the user with configuration means arranged to enable configuring one or more predetermined dependency rules for one or more user-selected signal processing modules. A dependency rule is arranged to indicate dependency between an input of a signal processing module and the output of the signal processing module. Moreover, a dependency rule may be applied to cause an exception to the processing rule employed to initiate carrying out the signal processing operations represented by the user-selected signal processing modules.

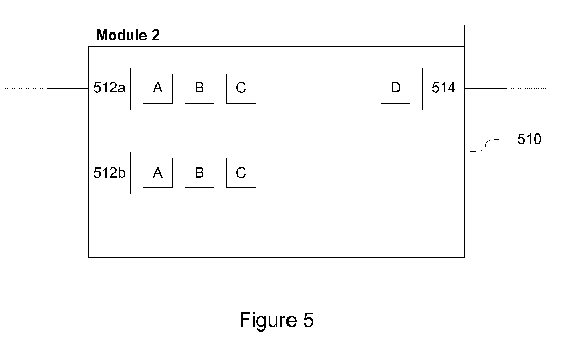

Figure 5 schematically depicts an exemplifying signal processing module 510. The signal processing module 510 comprises a first input 512a, a second input 512b and an output 514. The signal processing module 510 further comprises selection buttons A, B, and C for both inputs 512a and 514b and a selection button D for the output 514. The selection buttons A, B and C are provided for setting, respectively, the state of a first, second and third dependency rules for the respective input 512a, 512b. The selection button D is provided for setting the state of a fourth rule dependency. Setting the state of a dependency rule may comprise enabling (activating) the dependency rule or disabling (deactivating) the dependency rule. Instead of using a selection button e.g. a radio button or another corresponding GUI element may be employed as state control means arranged to enable activating or deactivating (enabling or disabling) the respective dependency rule. The GUI element providing the state control means is, preferably, arranged to provide a visual cue regarding its status, e.g. whether the corresponding dependency rule enabled (activated) or disabled (deactivated).

The signal processing module 510 may be a predetermined signal processing module representing one or more predefined signal processing operations or a user-definable signal processing module representing user-defined (or user-definable) signal processing operation(s). Although depicted with state control means for controlling state of three exemplifying dependency rules (that will be described in the following in more detail) for all inputs of the signal processing module 510 and a single rule for the output of the signal processing module 510, any limited subset of the state control means, possibly together with state control means arranged to control state of further dependency rules, may be applied.

As an example, the control button A may be provided as the state control means arranged to enable activating or deactivating a first exemplifying dependency rule for the respective input 512a, 512b. When enabled, the first dependency rule may be arranged to cause the signal processing application to refrain from initiating the signal processing operation(s) represented by the signal processing module 510 in response to detecting an event in the respective input 512a, 512b. As described in the foregoing, the event may comprise obtaining a new value or detecting a change of value in the respective input 512a, 512b. In case the processing rule is arranged to trigger carrying out the signal processing operation(s) represented by the signal processing module 510 in response to a detected event, the first dependency rule may be applied to reduce computational load caused by the signal processing arrangement by identifying a non-critical (or less important) input 512a, 512b.

As another example, the control button B may be provided as the state control means arranged to enable activating or deactivating a second exemplifying dependency rule for the respective input 512a, 512b. When enabled, the second dependency rule may be arranged to serve as an indication that there is a feedback loop to the respective input 512a, 512b from the output of a signal processing module of the signal processing arrangement whose input depends on the output 514 of the signal processing module 510. In other words, active (or enabled) state of the second dependency rule indicates that there is a feedback loop from the output 514 to an input 512a, 512b, either directly or via one or more other signal processing modules. Consequently, the signal processing application may be arranged to refrain from carrying out the signal processing operation(s) represented by the signal processing module 510 in response to detecting an event in an input 512a, 512b for which the second dependency rule is activated (enabled) in order to avoid an infinite processing loop in this regard in case an event-based processing rule is applied.

As a further example, the control button C may be provided as the state control means arranged to enable activating or deactivating a third exemplifying dependency rule for the respective input 512a, 512b. When enabled, the third dependency rule may be arranged to cause the signal processing application to apply a predetermined default value or a user-definable default value instead of the value received via the respective input 512a, 512b in response to a failure to obtain a valid value for the respective input 512a, 512b. A failure to obtain a valid value may include e.g. a failure to obtain (or receive) any value or obtaining (receiving) a value that is outside a predefined range and hence considered as an invalid input value. In this regard, the GUI may be configured to provide the user with definition means arranged to enable defining the default value and possibly also to enable defining the predefined range of valid input values. The third dependency rule may hence be applied e.g. to enable carrying out the signal processing operations represented by the signal processing arrangement even though some of the input values have not yet been received. As another example, the third dependency rule may be applied to provide a constant value for one of the inputs 512a, 512b (e.g. by setting a desired default value to an input 512a, 512b but not connecting the respective input 512a, 512b to an input of the signal processing arrangement or to an output of a user-selected signal processing module) .

As a yet further example, the control button D may be provided as the state control means arranged to enable activating or deactivating a fourth exemplifying dependency rule for the output 514. When enabled, the fourth dependency rule may be arranged to cause the signal processing application to refrain from providing an updated result of the signal processing operation(s) represented by the signal processing module 510 via the output 514 in response to result of the respective signal processing operation(s) exhibiting the same value as in the previous processing round. In other words, even though there is an event (e.g. a new or changed value) detected in one of the inputs 512a, 512b and, consequently, the signal processing operation represented by the signal processing module 510 is carried out, no new output (possibly resulting in detecting an event in a subsequent signal processing module in the processing chain) is provided via the output 514 in case the result of the signal processing operation is not changed due to the detected event.

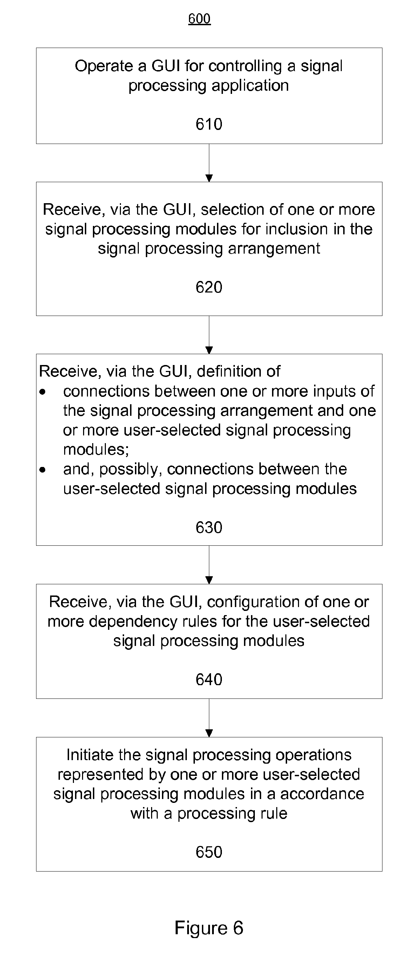

The operations, procedures and/or functions described in context of the signal processing application and/or the GUI may be also described as steps of a method. As an example in this regard, Figure 6 depicts a flowchart illustrating an exemplifying method 600 for carrying out operations, procedures and/or functions described in detail by the examples provided in the foregoing. The method 600 proceeds from operating and/or providing (e.g. 'running') the signal processing application and/or the GUI for defining, configuring and/or controlling a signal processing algorithm, as indicated in block 610. The method 600 further comprises receiving, via the GUI, selection of one or more signal processing modules for inclusion to the signal processing arrangement, as indicated in block 620. As described in the foregoing, each signal processing module represents one or more respective signal processing operation that involve computing one or more outputs of the signal processing module on basis of one or more inputs of the signal processing module.

The method 600 further comprises receiving, via the GUI, definition of connections between said one or more inputs of the signal processing arrangement and one or more user-selected signal processing modules and, possibly, connections between the user-selected signal processing modules to configure the signal processing arrangement, as indicated in block 630. The method 600 further comprises receiving, via the GUI, configuration of one or more dependency rules for the user-selected signal processing modules, as indicated in block 640. As described in the foregoing, a dependency rule is arranged to indicate a dependency between an input and the output of a respective signal processing module. The method 600 further comprises initiating carrying out the signal processing operations represented by one or more user-selected signal processing modules in accordance with the processing rule, as indicated in block 650.

The method steps indicated in blocks 610 to 650 may be varied in a number of ways, e.g. as described in the foregoing in context of the examples describing the operation and/or structure of the signal processing application and/or the GUI.

The computer program code 135 may be provided at the computer apparatus 110 via any suitable delivery mechanism. As an example, the delivery mechanism may comprise at least one computer readable non-transitory medium having the computer program code 135 stored thereon, the computer program code 135 which when executed by the computer apparatus 110 cause the computer apparatus 110 at least to carry out operations, procedures and/or functions described hereinbefore in context of the signal processing application and/or the GUI. The delivery mechanism may be, for example, a computer readable storage medium, a computer program product, a memory device a record medium such as a CD-ROM, a DVD, a Blue-Ray disc or another article of manufacture that tangibly embodies the computer program 135. As a further example, the delivery mechanism may be a signal configured to reliably transfer the computer program 135.

Reference to a processor (e.g. the processor 120) should not be understood to encompass only programmable processors, but also dedicated circuits such as field-programmable gate arrays (FPGA), application specific circuits (ASIC), signal processors, etc.Features described in the preceding description may be used in combinations other than the combinations explicitly described. Although functions have been described with reference to certain features, those functions may be performable by other features whether described or not. Although features have been described with reference to certain embodiments, those features may also be present in other embodiments whether described or not.

## Claims

1. An apparatus (110) comprising at least one processor (120) and at least one memory (130) including computer program code (135) for one or more programs, the at least one memory (130) and the computer program code (135) configured to, with the at least one processor (120), cause the apparatus (110) at least to:
provide a graphical user interface, GUI, for controlling a signal processing arrangement for processing one or more input signals via one or more user-selectable and user-configurable signal processing modules, wherein the GUI is configured to provide a user with
selection means arranged to enable selecting one or more signal processing modules (210, 210', 310, 320, 330, 420, 430, 510) for inclusion in the signal processing arrangement, wherein each signal processing module represents one or more respective signal processing operations that involve computing one or more outputs (214a, 214a', 214b', 314, 324, 334, 514) of the signal processing module on basis of one or more inputs (212a, 212b, 212a', 212b', 212c', 212d', 312a, 312b, 322a, 332a, 332b, 422, 432, 512a, 512b) of the signal processing module,
definition means arranged to enable defining connections between signal processing modules (210, 210', 310, 320, 330, 420, 430, 510) selected for inclusion in the signal processing arrangement and between one or more inputs (202a, 202b, 202c, 202d) of the signal processing arrangement and signal processing modules selected for inclusion in the signal processing arrangement to configure the signal processing arrangement, and
initiate carrying out the signal processing operations represented by said signal processing modules (210, 210', 310, 320, 330, 420, 430, 510) selected for inclusion in the signal processing arrangement in accordance with a processing rule,
**characterized in that** said processing rule is arranged to cause the apparatus to initiate, in response to detecting an event in one of the inputs (212a, 212b, 212a', 212b', 212c', 212d', 312a, 312b, 322a, 332a, 332b, 422, 432, 512a, 512b) of a signal processing module selected for inclusion in the signal processing arrangement, carrying out the signal processing operation represented by the respective signal processing module (210, 210', 310, 320, 330, 420, 430, 510), wherein an event in an input of a signal processing module comprises a new value being pushed via the respective input of the respective signal processing module, and
the GUI is configured to provide a user with configuration means comprising, for each input (212a, 212b, 212a', 212b', 212c', 212d', 312a, 312b, 322a, 332a, 332b, 422, 432, 512a, 512b) of each signal processing module selected for inclusion in the signal processing arrangement, a state control means (A, B, C) arranged to enable enabling or disabling one or more predefined dependency rules for the respective input, wherein a predefined dependency rule, when enabled, is arranged to cause an exception to said processing rule for the respective signal processing module (210, 210', 310, 320, 330, 420, 430, 510).

2. An apparatus according to claim 1, wherein the GUI is configured to cause the apparatus to display, via a display of the apparatus, at least the following:
said signal processing modules selected for inclusion in the signal processing arrangement,
said user-defined connections between said signal processing modules selected for inclusion in the signal processing arrangement, and
said user-configured status of said one or more predetermined dependency rules for said signal processing modules selected for inclusion in the signal processing arrangement.

3. An apparatus according to claim 1 or 2, wherein said definition means are configured to enable
defining a connection from an input of the signal processing arrangement to an input of a signal processing module selected for inclusion in the signal processing arrangement, and
defining a connection from an output of a signal processing module selected for inclusion in the signal processing arrangement to one of the following: an input of another signal processing module selected for inclusion in the signal processing arrangement, an input of the same signal processing module selected for inclusion in the signal processing arrangement.

4. An apparatus according to any of claims 1 to 3,
wherein the output of a signal processing module further represents an output of the signal processing arrangement as an output of a predetermined type to a user-definable target, and
wherein the GUI is configured to provide the user with definition means arranged to enable defining said target.

5. An apparatus according to any of claims 1 to 3, wherein
wherein said selection means are arranged to enable selecting one or more reporting modules for inclusion to the signal processing arrangement, wherein each reporting module represents provision of an input of the reporting module as an output of the signal processing arrangement as an output of a predetermined type to a user-definable target,
wherein said definition means are arranged to enable defining a connection between an output of a user-selected signal processing module and an input of a reporting module, and
wherein the GUI is configured to provide the user with definition means arranged to enable defining said target.

6. An apparatus according to claim 4 or 5, wherein said output of predetermined type comprises one of the following:
a file in a file system of the apparatus,
a graphical representation provided by the GUI,
a remote apparatus.

7. An apparatus according to any of claims 1 to 6, wherein said one or more dependency rules comprise a first dependency rule that, when enabled, causes refraining from initiating the signal processing operation represented by the respective signal processing module in response to a detected event in the respective input.

8. An apparatus according to any of claims 1 to 7, wherein said one or more dependency rules comprise a second dependency rule that, when enabled, serves as a definition that there is a feedback loop to the respective input from the output of a signal processing module whose input depends on the output of the respective signal processing module.

9. An apparatus according to any of claims 1 to 8, wherein said one or more dependency rules comprise a third dependency rule that, when enabled, causes applying a user-definable default value instead of the respective input in response to a failure to obtain a valid value for the respective input.

10. An apparatus according to any of claims 1 to 9, wherein said configuration means comprises, for the output of each signal processing module selected for inclusion in the signal processing arrangement, a further state control means arranged to enable enabling or disabling a fourth dependency rule, which fourth dependency rule, when enabled, causes initiating the signal processing operation represented by the respective signal processing module in response to detecting an event in one of the inputs of the respective signal processing module but refraining from providing an updated result of the signal processing operation represented by the respective signal processing module via its output in response to the result of the signal processing operation exhibiting the same value as in the previous processing round of this signal processing operation.

11. An apparatus according to any of claims 1 to 10, wherein the apparatus is caused to provide the one or more inputs of a signal processing module for a remote apparatus for carrying out the signal processing operation represented by the respective signal processing module and to receive the result of said signal processing operation from the remote server for provision via the output of the respective signal processing module.

12. An apparatus according to any of claims 1 to 10, wherein the apparatus is caused to provide the one or more inputs of the signal processing arrangement for a remote apparatus for carrying out the signal processing operation represented by the signal processing modules included in the signal processing arrangement and to receive the results of said signal processing operations from the remote server for provision via the outputs of the respective signal processing modules.

13. An apparatus according to any of claims 1 to 12, wherein said state control means comprise one or more selection buttons arranged in the respective signal processing module, each arranged to enable enabling or disabling respective one of said one or more dependency rules.

14. A method (600) comprising
providing (610) a graphical user interface, GUI, for controlling a signal processing arrangement for processing one or more input signals via one or more user-selectable and user-configurable signal processing modules,
receiving (620), via the GUI, selection of one or more signal processing modules (210, 210', 310, 320, 330, 420, 430, 510) for inclusion in the signal processing arrangement, wherein each signal processing module represents one or more respective signal processing operations that involve computing one or more outputs (214a, 214a', 214b', 314, 324, 334, 514) of the signal processing module on basis of one or more inputs (212a, 212b, 212a', 212b', 212c', 212d', 312a, 312b, 322a, 332a, 332b, 422, 432, 512a, 512b) of the signal processing module,
receiving (630), via the GUI, definition of connections between signal processing modules (210, 210', 310, 320, 330, 420, 430, 510) selected for inclusion in the signal processing arrangement and between one or more inputs (202a, 202b, 202c, 202d) of the signal processing arrangement and signal processing modules selected for inclusion in the signal processing arrangement to configure the signal processing arrangement, and
initiating (650) carrying out the signal processing operations represented by said signal processing modules (210, 210', 310, 320, 330, 420, 430, 510) selected for inclusion in the signal processing arrangement in accordance with a processing rule,
**characterized in that** said processing rule causes initiating, in response to detecting an event in one of the inputs (212a, 212b, 212a', 212b', 212c', 212d', 312a, 312b, 322a, 332a, 332b, 422, 432, 512a, 512b) of a signal processing module selected for inclusion in the signal processing arrangement, carrying out the signal processing operation represented by the respective signal processing module (210, 210', 310, 320, 330, 420, 430, 510), wherein an event in an input of a signal processing module comprises a new value being pushed via the respective input of the respective signal processing module, and
receiving (640), via the GUI, for each input (212a, 212b, 212a', 212b', 212c', 212d', 312a, 312b, 322a, 332a, 332b, 422, 432, 512a, 512b) of each signal processing module selected for inclusion in the signal processing arrangement, configuration of a state control means (A, B, C) arranged to enable enabling or disabling one or more predefined dependency rules for the respective input, wherein a predefined dependency rule, when enabled, is arranged to cause an exception to said processing rule for the respective signal processing module (210, 210', 310, 320, 330,420,430,510).

15. A computer program comprising one or more sequences of one or more instructions which, when executed by one or more processors, cause an apparatus to at least carry out the method according to claim 14.
